## Europäisches Patentamt
## European Patent Office
## Office européen des brevets

(11) Numéro de publication: **0 060 164**
**B1**

(12) **FASCICULE DE BREVET EUROPEEN**

(45) Date de publication du fascicule du brevet:
**10.10.84**

(21) Numéro de dépôt: **82400279.4**

(22) Date de dépôt: **17.02.82**

(51) Int. Cl.³: **H 03 F 1/02,** H 03 G 3/00

(54) Amplificateur linéaire à faible consommation et à large bande, fonctionnant en classe A glissante, et circuit comportant au moins un tel amplificateur.

(30) Priorité: **27.02.81 FR 8103988**

(43) Date de publication de la demande:
**15.09.82 Bulletin 82/37**

(45) Mention de la délivrance du brevet:
**10.10.84 Bulletin 84/41**

(84) Etats contractants désignés:
**AT BE CH DE GB IT LI LU NL SE**

(56) Documents cités:
**DE - A - 2 834 641**
**US - A - 3 166 719**
**US - A - 3 872 247**

(73) Titulaire: **THOMSON-CSF, 173, Boulevard Haussmann, F-75379 Paris Cedex 08 (FR)**

(72) Inventeur: **Najman, Michel, THOMSON-CSF SCPI 173, bld Haussmann, F-75360 Paris Cedex (FR)**

(74) Mandataire: **Courtellemont, Alain et al, THOMSON-CSF SCPI 173, Bld Haussmann, F-75379 Paris Cedex 08 (FR)**

BUNDESDRUCKEREI BERLIN

## Description

La présente invention se rapporte à un amplificateur linéaire, à faible consommation et à large bande passante, présentant par ailleurs des impédances d'entrée et de sortie très faibles. La présente invention se rapporte également aux circuits amplificateurs à commande automatique de gain comportant au moins un de ces amplificateurs, précédé d'un élément résistif dont la valeur varie en fonction de la valeur du signal de commande ge gain qui lui est appliqué.

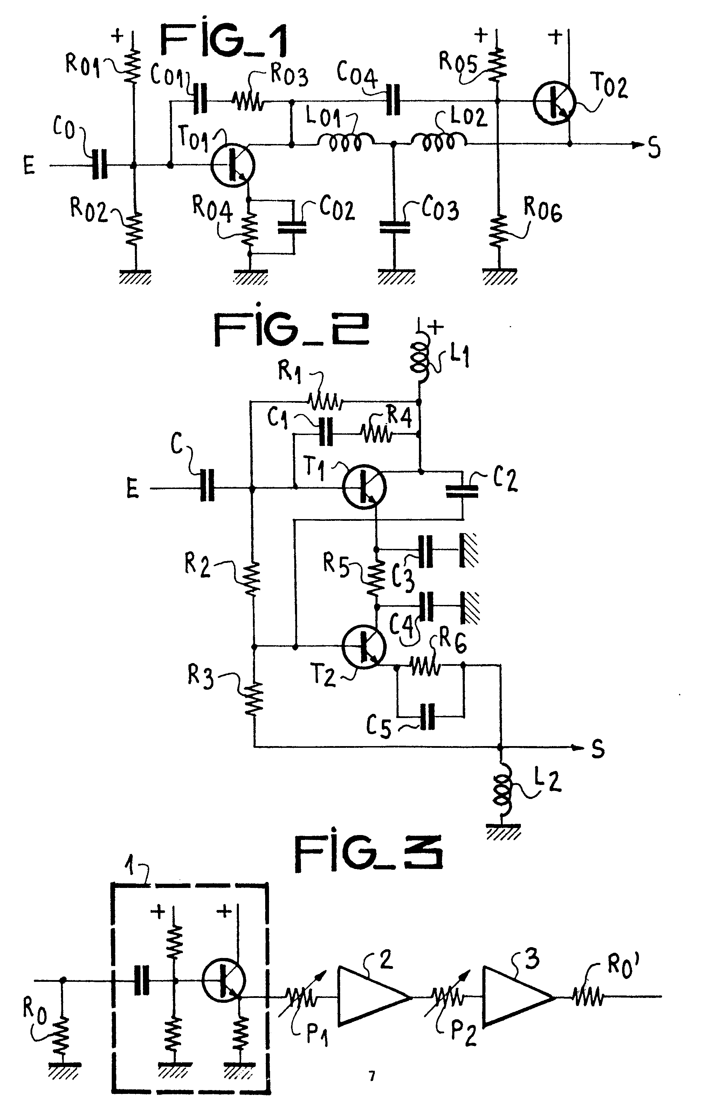

De tels amplificateurs sont connus et un exemple de réalisation d'un de ces amplificateurs connus sera donné à l'aide de la figure 1 dont la description est faite plus loin.

La recherche d'impédances nulles aux accès de ces amplificateurs et d'un découplage important dans le sens accès de sortie-accès d'entrée conduit à utiliser des montages à deux transistors dont le premier est monté en émetteur commun et comporte un circuit de contre-réaction shunt et dont le second est monté en collecteur commun. La recherche d'une faible consommation conduit à monter les deux transistors en série. Quant à la recherche de linéarité, elle conduit à faire fonctionner les deux transistors en classe A.

Parmi les amplificateurs connus, les plus performants comportent, en série entre les deux bornes de leur alimentation en continu, une cellule »résistance-condensateur en parallèle«, suivie du transistor d'entrée de l'amplificateur, suivi du transistor de sortie; le point de repos du fonctionnement en classe A est fixe et est déterminé par la valeur de la résistance de la cellule et la polarisation de la base du transistor d'entrée. Ce point de repos est choisi en fonction de l'amplitude maximum des signaux d'entrée à amplifier. Avec ces amplificateurs, même lorsque le signal d'entrée n'est pas au maximum de sa valeur, c'està-dire en général pendant la majeure partie du fonctionnement, le courant à fournir par l'alimentation est aussi important que lorsque le signal d'entrée est au maximum de sa valeur. De plus avec ces amplificateurs connus apparaît un déphasage du signal de sortie sur le signal d'entrée lié au niveau du signal d'entrée et qui peut êntre gênant, quand le signal d'entrée est important; ce déphasage est dû à une non linéarité du composant.

La présente invention a pour but de réduire très sensiblement ces inconvénients sans pour cela nécessiter des circuits plus chers ou plus compliqués.

Ceci est obtenu en réinjectant une partie du signal de sortie de l'amplificateur sur la base de son transistor de sortie et en faisant fonctionner l'amplificateur en classe A glissante, c'est-à-dire en classe A avec modification du point de repos en fonction de l'amplitude des signaux d'entrée à amplifier; dans ce qui suit et dans les revendications, quand il sera question de classe A glissante c'est de ce genre de fonctionnement dont il s'agira.

La présente invention sera mieux comprise et d'autres caractéris tiques apparaîtront à l'aide de la description ci-après et des figures s'y rapportant qui représentent:

- la figure 1, un schéma d'un amplificateur linéaire selon l'art connu,
- la figure 2, un schéma d'un amplificateur linéaire selon la présente invention,
- la figure 3, un schéma d'un circuit amplificateur à gain variable équipé d'amplificateurs selon la figure 2.

La figure 1 montre un amplificateur à deux transistors n-p-n, T01, T02, dont le premier monté en émetteur commun constitue le transistor d'entrée, l'entrée E de l'amplificateur étant reliée par un condensateur C0 à la base de ce transistor; le second transistor, monté en collecteur commun, constitue le transistor de sortie, la sortie S de l'amplificateur étant constituée par l'émetteur de de transistor. La polarisation de la base des transistors T01, T02 est obtenue au moyen de deux ponts de résistances R01—R02 et R05—R06 connectés entre une borne à un potentiel positif, indiqué + sur la figure 1, et la masse.

Le transistor T01 comporte un circuit de contre-réaction shut, C01—R03, entre sa base et son collecteur, pour abaisser son impédance d'entrée. Le transistor T01 est chargé par une impédance élevée en alternatif pour avoir un gain maximum en tension; cette impédance est constituée par une inductance L01 branchée entre son collecteur et la première borne d'un condensateur, C03, dont la seconde borne est réunie à la masse. Une cellule de découplage par une résistance, R04, en parallèle sur un condensateur, C02, relie l'émetteur du transistor T01 à la masse.

Un condensateur C04 relie le collecteur du transistor d'entrée T01 à la base du transistor de sortie T02. Ce transistor de sortie est monté en collecteur commun avec son collecteur relié au potentiel + et est chargé, comme le transistor T01, par une impédance élevée en alternatif afin de pouvoir délivrer un maximum de puissance sur la charge destinée à êntre montée sur la sortie S de l'amplificateur.

Dans le montage selon la figure 1 les deux transistors fonctionnent en classe A et leurs courants de collecteur sont sensiblement identiques et égaux à $\dfrac{Ve}{R04}$ où. Ve est la tension continue sur l'émetteur du transistor T01 et est déterminée par la polarisation de la base de ce transistor; dans ce montage, comme il a déjà été indiqué plus avent le courant fourni par l'alimentation, c'est-à-dire sensiblement $\dfrac{Ve}{R04}$, est le même que le signal à amplifier soit de fort ou de faible niveau.

La figure 2 montre un amplificateur à deux transistors n-p-n, T1, T2, qui, comme pour l'amplificateur de la figure 1, sont montés en émetteur commun pour le premier et en collecteur commun pour le second.

L'entrée E de l'amplificateur est réunie par un condensateur C à la base du transistor T1. La polarisation des bases des transistors T1, T2 est assurée par un pont d'impédance constitué par la mise en série, entre un point de potentiel positif égal à +8V et noté + sur la figure 2 et la masse, d'une inductance L1, d'une résistence R1, d'une résistance R2, d'une résistance R3 et d'une inductance L2; la base du transistor T1 est reliée au point commun aux résistances R1 et R2 et la base du transistor T2 est reliée au point commun aux résistances R2 et R3.

Comme dans le cas de la figure 1 le transistor d'entrée, T1, de la figure 2 comporte un circuit de contre-réaction shunt, C1—R4, entre sa base et son collecteur, pour abaisser son impédance d'entrée.

Le collecteur du transistor T1 est relié d'une part au point commun à l'impédance L1 et à la résistance R1 et d'autre part, à travers un condensateur C2, à la base du transistor de sortie T2.

L'émetteur du transistor T1 est relié, à travers une résistance R5, au collecteur du transistor T2 et les deux bornes de la résistance R5 sont de plus reliées à la masse respectivement par deux condensateurs C3 et C4. Quant à l'émetteur du transistor T2 il est réuni, par une cellule constituée d'une résistance R6 en parallèle sur un condensateur C5, au point commun entre la résistance R3 et l'inductance L2, ce point commun constituant la sortie S de l'amplificateur.

En plus des analogies déjà indiquées de ce montage avec celui selon la figure 1 il est à remarquer que là aussi les deux transistors sont en série entre les deux bornes de l'alimentation (potentiel + et masse) et qu'ils sont chargés par des impédances élevées en alternatif, constituées par les inductances L1 et L2.

Par contre dans le montage de la figure 2 la polarisation des bases des deux transistors se fait par un même pont de polarisation et ce pont n'est plus simplement braché entre les deux bornes de l'alimentation (+ et masse) mais relie la borne de sortie, S, au point de potentiel + en passant par les bases des deux transistors; d'autre part la cellule R04—C02 qui déterminait, avec la polarisation de la base du transistor d'entrée, le courant d'alimentation des deux transistors de la figure 1, est remplacée par une cellule R6—C5 branchée entre l'émetteur du transistor T2 et la sortie S; cette cellule détermine, en fonction de la tension sur la base du transistor T2, le courant d'alimentation, Ia, qui est sensiblement le même pour les deux transistor et qui vaut, tant que les signaux à amplifier sont de faible niveau

$$Ia = \frac{Vb - Vbe}{R6}$$

où Vb la tension continue sur la base du transistor T2 et Vbe la tension base-émetteur du transistor T2.

La cellule R6—C5 constituant, avec la diode base-émetteur du transistor T2, un circuit de détection, entraîne une augmentation de la tension continue aux bornes de la résistance R6 dès que les signaux à amplifier ont un niveau suffisant pour que la tension alternative sur la base du transistor T2 dépasse le seuil de détection de ce détecteur. Le courant d'alimentation devient alors

$$Ia = \frac{Vb - Vbe + Vd}{R6}$$

où Vd est la tension détectée; le fonctionnement est alors un fonctionnement en classe A glissante pour les deux transistor T1 et T2 puisque leur courant continu émetteur-collecteur croît à mesure que le niveau du signal d'entrée augmente; ceci a pour effet de diminuer très fortement la conversion amplitude-phase par rapport à ce qui observé avec un amplificateur selon la figure 1.

Un autre aventage de l'amplificateur selon la figure 2 par rapport à celui selon la figure 1 est sa plus grande facilité de réalisation en microcircuits; en effet, étant donné que, les inductances ne peuvent être réalisées en microcircuits, le microcirciut pour léamplificateur selon la figure 1 doit comporter six bornes (E, S, +, masse et les deux extrémités de l'inductance L01) alors que celui pour l'amplification selon la figure 2 n'en nécessite que quatre (E, S, masse et point commun entre l'inductance L1 et la résistance R1).

L'amplificateur selon la figure 2 a été réalisé avec les éléments suivants:

T1, T2: transistors NEO21—35 de N.E.C.
L1 = L2 = 10 H
C = C1 = C2 = C3 = C4 = C5 = 10 nF
R1 = 2,2 k.ohms
R2 = 3 k.ohms
R3 = 1,6 k.ohms
R4 = 820 ohms
R5 = 22 ohms
R6 = 68 ohms

les caractéristiques de cet amplificateur sont les suivantes;

gain: 11 dB,
bande passante: 5 MHz — 300 MHz à 3 dB avec une partie plate de 10 à 100 MHz,
consommation: 12,5 mA avec un signal d'entrée à faible niveau et 16 mA un signal d'entrée à fort niveau.

D'autres réalisations d'amplificateurs peuvent être proposées sans sortir du cadre de l'invention; c'est ainsi que le montage selon la figure 2 peut être réalisé en transistor p-n-p en remplaçant le point de potentiel positif, +, par un point de potentiel négatif et en adaptant la valeur de ce potentiel et les valeurs des résistances du pont de polarisation de la base des transistor aux caractéristiques de ces transistor.

De même la polarisation de la base des deux transistors peut être réalisée à l'aide de deux ponts d'impédances distincts.

Du fait de ses faibles impédances d'entrée, et de sortie, de sa faible consommation et de sa grande linéarité due au fonctionnement en classe A glissante, l'amplificateur selon la figure 2 se prête tout spécialement bien à la réalisation de circuits amplificateurs à gain variable comme celui schématisé sur la figure 3.

La figure 3 montre un circuit amplificateur à commande de gain variable constitué d'une résistance R0 suivie d'un amplificateur 1, d'une impédance de liaison P1, d'un amplificateur 2, d'une impédance de liaison P2, d'un amplificateur 3 et d'une résistance R0'. Dans ce montage les amplificateurs 2,3 sont identiques à l'amplificateur selon la figure 2, les résistances R0 et R0' sont des résistances d'adaptation d'une valeur de 50 ohms et les impédances de liaison P1, P2, symbolisées par une résistance variable, sont en fait des circuits résistifs à impédance variable, fonction de la valeur du signal appliqué sur leur entrée de commande. Quant au circuit 1, c'est un amplificateur de gain 0 dB classique, jouant le rôle de séparateur d'impédances de manière que soit toujours vue, à l'entrée du circuit amplificateur, une impédance de valeur R0, quelle que soit la valeur prise par P1. Un tel circuit amplificateur a un gain pouvant varier de 0 à 22 dB. Il est également possible de réaliser des circuits amplificateurs ne comportant, entre l'amplificateur 1 et la résistance R0', que l'ensemble composé d'un amplificateur (2) et de son impédance associée (P1) ou comportant plus de deux de ces ensembles montés en série entre l'amplificateur 1 et la résistance R0'; il est également possible de réaliser de tels circuits amplificateurs à commande de gain comportant plusieurs amplificateurs que 2 mais dont une partie seulement des impédances y associées, telles que P1, serait variable. Dans le circuit amplificateur selon la figure 3 il est à noter que le circuit 1 peut être remplacé par un amplificateur selon la figure 2 qui introduira un gain constant de 11 dB et aura le rôle de séparateur d'impédances.

## Revendications

1. Amplificateur linéaire, à faible consommation et large bande passante comportant un transistor d'entrée (T1) et un transistor de sortie (T2) chargés par des impédances élevées en alternatif (L1, L2) et dont les jonctions collecteur-émetteur sont montées en série entre les deux bornes de son alimentation en continu, caractérisé en ce que, de manière à réinjecter une partie du signal de sortie sur la base du transistor de sortie et à déterminer un fonctionnement en classe A glissante des deux transistors, il comporte un pont de polarisation (R₁—R₃) des bases des transistors, relié à la sortie (S) de l'amplificateur et à l'électrode de sortie du transistor d'entrée, et une cellule »résistance-condensateur en parallèle« (R6—C5) branchée entre l'électrode de sortie du transistor de sortie et la sortie de l'amplificateur pour jouer, avec la diode base-émetteur du transistor de sortie, le rôle de circuit de détection.

2. Circuit amplificateur à commande de gain, caractérisé en ce qu'il comporte: une impédance d'entrée de valeur donnée (R0) suivie d'un circuit séparateur d'impédances (1), suivi de n circuits en série (n entier positif) composés chacun d'une impédance de liason (P1) et d'un amplificateur linéaire (2,3) selon la revendication 1, suivis d'une impédance (R0') de valeur égale à la valeur donnée et en ce que au moins l'une des n impédance de liaison est variable.

## Patentansprüche

1. Linearer Verstärker mit niedrigem Verbrauch und breitem Durchlaßband, der einen Eingangstransistor (T1) und einen Ausgangstransistor (T2) umfaßt, welche bei Wechselstrom durch hohe Impedanzen (L1, L2) belastet sind und deren Kollektor-Emitter-Strecken in Reihe zwischen zwei Gleichspannungsversorgungsanschlüsse geschaltet sind, dadurch gekennzeichnet, daß er, in solcher Weise, daß ein Teil des Ausgangssignals zur Basis des Ausgangstransistors zurückgespeist wird und eine Betriebsweise in gleitender Klasse A für die beiden Transistoren bestimmt wird, eine Polarisationsbrücke (R₁—R₃) zum Polarisieren der Basen der Transistoren umfaßt, welche mit dem Ausgang (S) des Verstärkers und der Ausgangselektrode des Eingangstransistors verbunden ist, sowie ein »Widerstand-Parallelkondensator-Glied« (R6—C5) umfaßt, welches zwischen die Ausgangselektrode des Ausgangstransistors und den Ausgang des Verstärkers geschaltet ist, um gemeinsam mit der Basis-Emitter-Diode des Ausgangstransistors die Funktion einer Detektionsschaltung zu erfüllen.

2. Verstärkerschaltung mit Verstärkungssteuerung, dadurch gekennzeichnet, daß sie umfaßt: eine Eingangsimpedanz (R0) gegebenen Wertes, auf die eine Impedanztrennungsschaltung (1) folgt, gefolgt von n in Reihe liegenden Schaltungen (n ganzzahlig positiv), die jeweils gebildet sind aus einer Verbindungsimpedanz (P1) und einem linearen Verstärker (2,3) nach Anspruch 1, gefolgt von einer Impedanz (R0'), deren Wert derselbe ist wie der gegebene Wert, und daß wenigstens eine der n Verbindungsimpedanzen variabel ist.

## Claims

1. Linear amplifier having a reduced consumption and a wide pass-band, comprising an input transistor (T1) and an output transistor (T2) loaded by high impedances (L1, L2) at a. c., and the collector-emitter junctions of which are mounted in series between its two d. c. supply terminals, characterized in that, in a manner to feed a portion of the output signal back into the base of the output transistor and to determine a sliding class A operation of the two transistors, it comprises a polarization bridge ($R_1$, $R_3$) for the bases of these transistors which is connected to the output (S) of the amplifier and to the output electrode of the input transistor, and a »resistor-parallel capacitor unit« ($R6 - C5$) connected between the output electrode of the output transistor and the output of the amplifier in a manner to perform, with the base-emitter diode of the output tranistor, the operation of a detection circuit.

2. Gain controlled amplifier circuit, characterized in that it comprises: an input impedance of given value (R0) followed by an impedance separator circuit (1) followed by n series connected circuits (n positive integer) each composed of a connection impedance (P1) and a linear amplifier (2,3) according to claim 1, followed by an impedance (R0') having a value identical to that of the given value, and in that at least one of the n connection impedances is variable.

0 060 164

FIG_1

FIG_2

FIG_3